## Europäisches Patentamt

## European Patent Office

## Office européen des brevets

(11) Numéro de publication: **0 067 091**
**A1**

---

## (12) DEMANDE DE BREVET EUROPEEN

(21) Numéro de dépôt: **82400901.3**

(22) Date de dépôt: **14.05.82**

(51) Int. Cl.³: **H 03 F 1/32**

---

(30) Priorité: **26.05.81 FR 8110451**

(43) Date de publication de la demande: **15.12.82**
**Bulletin 82/50**

(84) Etats contractants désignés: **CH DE GB IT LI NL**

(71) Demandeur: **THOMSON-CSF, 173, Boulevard Haussmann, F-75379 Paris Cedex 08 (FR)**

(72) Inventeur: **Gaudin, Daniel, THOMSON-CSF SCPI 173, bld Haussmann, F-75379 Paris Cedex 08 (FR)**
Inventeur: **Viaud, Jacques, THOMSON-CSF SCPI 173 bld Haussmann, F-75379Paris Cedex 08 (FR)**

(74) Mandataire: **El Manouni, Josiane et al, THOMSON-CSF SCPI 173, Bld Haussmann, F-75379 Paris Cedex 08 (FR)**

---

(54) **Dispositif de correction d'intermodulation produite par un amplificateur de signaux haute fréquence.**

(57) Ce dispositif de correction d'intermodulation produite par un amplificateur (1) de signaux haute fréquence comporte essentiellement un détecteur d'enveloppe (3) du signal haute fréquence à amplifier et des moyens (2) pour élaborer, à partir du signal à amplifier, des signaux de correction, d'amplitude réglabe, aux fréquences des produits d'intermodulation d'ordres impairs, ce qui permet de corriger les produits d'intermodulation d'ordres impairs produits par l'amplificateur (1), le produit des fonctions de transfert des moyens (2) et de l'amplificateur (1) ne donnant pas obligatoirement une fonction de transfert linéaire.

# DISPOSITIF DE CORRECTION D'INTERMODULATION PRODUITE PAR UN AMPLIFICATEUR DE SIGNAUX HAUTE FREQUENCE

La présente invention concerne un dispositif de correction d'intermodulation produite par un amplificateur de signaux haute fréquence.

La non linéarité d'un amplificateur provoque, lorsqu'il est excité simultanément par plusieurs signaux de fréquences différentes, des signaux parasites appelés produits d'intermodulation.

Lorsque les signaux haute fréquence à amplifier sont des signaux modulés, le phénomène d'intermodulation se traduit alors, en dehors de la bande de modulation, par une perturbation des communications utilisant des canaux voisins, et dans la bande de modulation, par une distorsion phonique et surtout par un accroissement du taux d'erreur en cas de transmission numérique multiporteuse.

Pour éviter de pareils effets, il convient de minimiser les conséquences du phénomène de non linéarité.

Diverses solutions ont été proposées pour cela. Elles peuvent se classer en deux catégories : les dispositifs à asservissement permanent et les dispositifs précorrecteurs.

Les dispositifs à asservissement permanent consistent à faire une contre-réaction des divers paramètres du signal à amplifier. Comme tous les systèmes bouclés ces dispositifs peuvent donner lieu à des parasites transitoires après une phase de silence. Les dispositifs précorrecteurs connus tendent à redonner globalement, c'est-à-dire y compris l'amplificateur à corriger, une fonction de transfert rectiligne, en compensant à la fois les termes de puissances paires et les termes de puissances impaires de la fonction de transfert de l'amplificateur à corriger.

Tous ces dispositifs ont en commun une grande complexité de réalisation et de mise au point. Par ailleurs ils doivent être conçus en fonction des amplificateurs qu'ils doivent corriger et ne sont jamais transposables directement à d'autres amplificateurs. De plus, ils s'appliquent difficilement aux amplificateurs large bande.

Il est également connu, d'après la demande de brevet allemand n° 2 306 294, de réaliser un précorrecteur en élaborant des signaux de correction à partir du signal haute fréquence à amplifier, par élévation de ce signal haute fréquence à différentes puissances, suivie d'un réglage de l'amplitude des signaux ainsi obtenus.

L'élévation du signal haute fréquence à des puissances impaires implique une correction globale des produits d'intermodulation, c'est-à-dire une correction à la fois des produits d'intermodulation d'ordres pairs et impairs.

De plus, du fait que ce précorrecteur opère directement sur le signal haute fréquence à amplifier, sa réalisation pratique, à base d'élévation à certaines puissances du signal haute fréquence à amplifier ne fait que découler purement et simplement du problème posé de compensation des puissances correspondantes de la fonction de transfert de l'amplificateur à corriger, et surtout cette réalisation présente de grandes difficultés de mise en oeuvre en pratique.

Selon l'invention, le dispositif de correction d'intermodulation produite par un amplificateur de signaux haute fréquence comporte des moyens pour élaborer des signaux de correction d'amplitude réglable aux fréquences des produits d'intermodulation d'ordres impairs, ce qui permet de corriger les produits d'intermodulation d'ordres impairs, le produit des fonctions de transfert de l'amplificateur et de ce dispositif de correction ne donnant pas nécessairement une fonction de transfert linéaire.

Selon une autre caractéristique de l'invention, le dispositif de correction élabore les signaux de correction à partir de l'enveloppe du signal haute fréquence à amplifier.

Le dispositif de correction selon l'invention présente donc une grande simplicité au plan technologique, ce qui facilite considérablement sa mise en oeuvre en pratique. De plus, contrairement au précorrecteur connu décrit précédemment, sa réalisation ne peut plus découler directement du problème posé et nécessite un effort de recherche particulier, comme on le verra dans la suite de la description.

Les objets et caractéristiques de la présente invention apparaîtront plus clairement à la lecture de la description suivante d'un exemple de réalisation, ladite description étant faite en relation avec les dessins ci- annexés dans lesquels :

- la figure 1 est un schéma d'un dispositif de correction d'intermodulation selon l'invention ;

- la figure 2 est une représentation spectrale des signaux obtenus en différents points du dispositif représenté à la figure 1.

On entend par produits d'intermodulation d'ordres impairs les raies du spectre qui se situent aux fréquences $nf_1 - (n-1)f_2$ et $(n-1)f_1 - nf_2$, où n est un nombre entier et $f_1$ et $f_2$ les fréquences d'émission.

A titre d'exemple, on décrit un dispositif de correction des produits d'intermodulation d'ordre 3 et 5 c'est-à-dire issus des termes de puissance égale à 3 et 5 de la fonction de transfert de l'amplificateur 1, mais le principe de l'invention reste valable pour la correction des produits d'intermodulation d'ordre supérieur à 5.

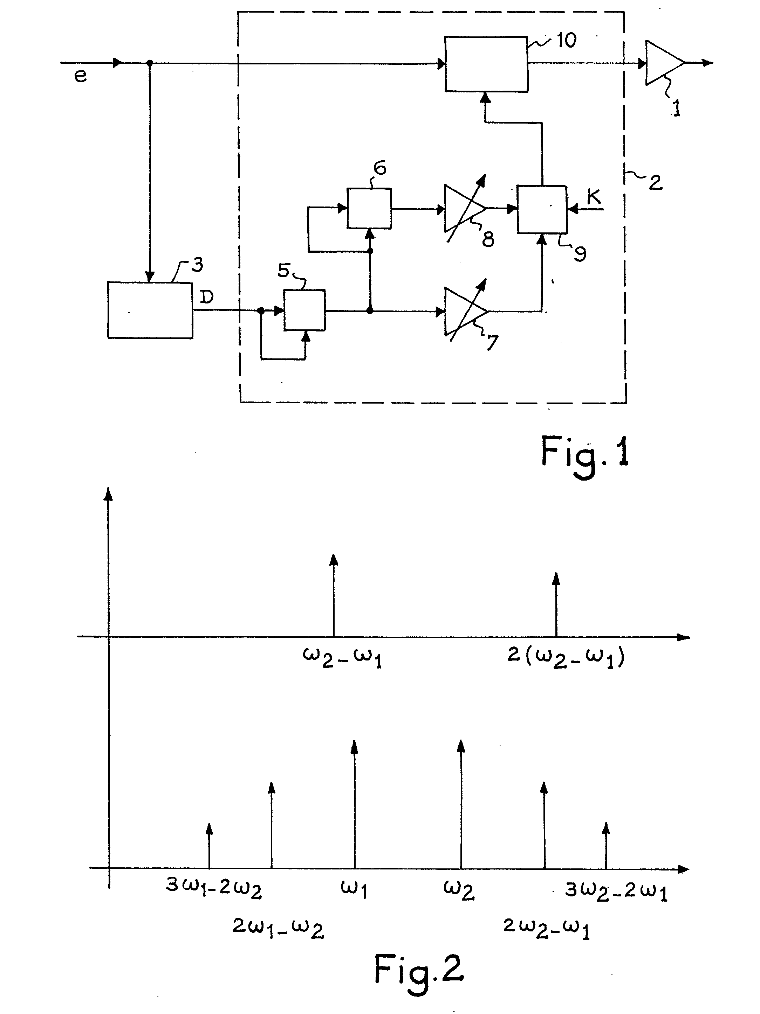

Sur la figure 1 on a représenté un amplificateur non linéaire 1 destiné à amplifier un signal d'entrée e de haute fréquence.

Un dispositif 2 de correction d'intermodulation produite par l'amplificateur 1 est disposé en amont de cet amplificateur. Conformément à un premier mode de réalisation de l'invention, il est prévu en amont du dispositif de correction 2 un détecteur 3 de l'enveloppe D du signal d'entrée de haute fréquence. Le détecteur 3 est constitué par exemple par un montage du type "diode sans seuil".

Dans le cadre de l'exemple choisi pour la description, le dispositif 2 de correction d'intermodulation comporte un premier multiplieur 5 muni de deux entrées reliées à la sortie du détecteur d'enveloppe 3, et un second multiplieur 6 muni de deux entrées reliées à la sortie du premier multiplieur 5.

Le dispositif 2 comporte également un premier amplificateur à gain réglable 7, muni d'une entrée reliée à la sortie du premier multiplieur 5, et un second amplificateur à gain réglable 8, muni d'une entrée reliée à la sortie du second multiplieur 6. Les amplificateurs 7 et 8 sont des amplificateurs linéaires, par exemple des amplificateurs opérationnels bouclés à l'aide d'une résistance.

Le dispositif 2 comporte également un circuit sommateur 9 muni d'une première entrée reliée à la sortie de l'amplificateur 7, d'une deuxième entrée reliée à la sortie de l'amplificateur 8 et d'une troisième entrée destinée à recevoir une valeur constante K déterminée par l'opérateur en fonction du point de fonctionnement désiré. Le circuit sommateur 9 est destiné à effectuer des additions ou des soustractions entre les valeurs disponibles sur chacune de ses entrées, le choix entre addition et soustraction relativement à chacune de ces valeurs étant déterminé par l'opérateur.

Plus généralement, le dispositif 2 comporte N multiplieurs dont le premier est muni de deux entrées reliées à la sortie du détecteur d'enveloppe, dont le deuxième est muni de deux entrées reliées à la sortie du premier et dont le $n^{\text{ième}}$ (n étant un entier compris entre 3 et N) est muni de deux entrées reliées respectivement à la sortie du premier et du $(n-1)^{\text{ième}}$, N amplificateurs linéaires à gain réglable munis chacun d'une entrée reliée à la sortie de l'un des N multiplieurs, et un circuit sommateur à "N+1" entrées, dont N sont reliées aux sorties des amplificateurs linéaires à gain réglable, et dont la $(N+1)^{\text{ième}}$ est destinée à recevoir la valeur constante K.

Le dispositif 2 comporte également un mélangeur 10 muni d'une première entrée qui reçoit le signal d'entrée e, d'une seconde entrée reliée à la sortie du circuit sommateur 9, et d'une sortie qui constitue la sortie du dispositif 2 et qui est reliée à l'entrée de l'amplificateur 1. Le mélangeur 10 est destiné à effectuer le produit des signaux présents sur ses deux entrées.

Le fonctionnement du dispositif 2 de correction d'intermodulation représenté à la figure 1 est maintenant expliqué en relation avec la figure 2.

Il est tout d'abord important de voir la relation entre les raies principales et les raies d'intermodulation produites par un amplificateur non linéaire. Soient e (t) et s (t) les signaux d'entrée et de sortie de cet amplificateur ; on a entre e (t) et s (t) une relation du type :

$$s\,(t) = ae\,(t) + be^2\,(t) + ce^3\,(t) + \ldots \text{ etc}$$ où a, b, c, ... etc sont des coefficients réels définissant la non linéarité de l'amplificateur.

Les termes pairs de s (t) ($e^2$, $e^4$ ... etc) ne produisent pas de raies parasites du voisinage des fréquences d'émission et ne sont donc pas gênants puisque, dans le cadre de la présente demande de brevet, on se préoccupe uniquement de la correction des produits d'intermodulation qui se trouvent au voisinage des fréquences d'émission, c'est-à-dire des produits d'intermodulation d'ordres impairs, en supposant par exemple que l'amplificateur non linéaire dispose de filtres harmoniques. Il suffit donc d'étudier une non linéarité ne comportant que des puissances impaires, et par exemple, pour la correction des produits d'intermodulation d'ordre 3 et 5, une non linéarité du type :

$$s(t) = ae(t) + ce^3(t)$$

On étudie ce type de non linéarité pour un signal d'entrée $e(t)$ comportant 2 tons égaux aux fréquences $f_1$ et $f_2$ :

$$e(t) = \cos \omega_1 t + \cos \omega_2 t.$$

En effectuant le calcul, on trouve que le signal $s(t)$ correspondant possède huit composantes spectrales : deux raies principales aux fréquences $f_1$ et $f_2$, deux raies d'intermodulation aux fréquences $2f_1 - f_2$ et $2f_2 - f_1$, deux raies d'intermodulation aux fréquences $2f_1 + f_2$ et $2f_2 + f_1$, donc au voisinage des harmoniques 3, et deux harmoniques 3 aux fréquences $3f_1$ et $3f_2$.

Le signal utile a donc pour équation après filtrage harmonique :

$$s(t) = \alpha(\cos \omega_1 t + \cos \omega_2 t) + \beta[\cos(2\omega_1 t - \omega_2 t) + \cos(2\omega_2 - \omega_1)t].$$

où $\alpha$ et $\beta$ sont des coefficients réels.

A la première ligne de la figure 2 on a représenté le spectre du signal obtenu en sortie du circuit sommateur 9 pour un signal d'entrée $e(t)$ comportant deux tons égaux aux fréquences $f_1$ et $f_2$ :

$$e(t) = \frac{A}{2}(\cos \omega_1 t + \cos \omega_2 t),$$

où A est un coefficient réel, ce qui s'écrit aussi :

$$e(t) = A \cos\left(\frac{\omega_1 + \omega_2}{2}t\right) \cos\left(\frac{\omega_2 - \omega_1}{2}t\right)$$

On remarque qu'il s'agit du produit d'un signal haute fréquence par un signal basse fréquence. Le signal basse fréquence représente l'enveloppe du signal d'entrée :

$$d = A \cos\left(\frac{\omega_2 - \omega_1}{2}\right) t$$

Soit x l'écart entre les fréquences $f_1$ et $f_2$. On obtient alors, en sortie du détecteur d'enveloppe 3 :

$$D = A \left| \cos \frac{x}{2} \right|$$

En sortie du premier multiplieur 5, on obtient $D^2 = \frac{A^2}{2} (1 + \cos x)$ et en sortie du second multiplieur 6 :

$$D^4 = \frac{A^4}{8} (3 + 4 \cos x + \cos 2x)$$

C'est pourquoi le spectre représenté à la première ligne de la figure 2 comporte trois composantes : une composante continue, une composante de pulsation $\omega_2 - \omega_1$, et une composante de pulsation $2(\omega_2 - \omega_1)$.

A la sortie du mélangeur 10 on obtient :

$$\frac{A}{2} (\cos \omega_1 t + \cos \omega_2 t) [ A' + B' \cos (\omega_2 - \omega_1)t + C' \cos 2(\omega_2 - \omega_1)t]$$

où A', B' et C' sont coefficients réels.

En effectuant le calcul, on trouve six composantes spectrales : aux fréquences $f_1$, $f_2$, $2f_1 - f_2$, $2f_2 - f_1$, $3f_1 - 2f_2$ et $3f_2 - 2f_1$.

Ce résultat apparait sur le spectre représenté à la deuxième ligne de la figure 2, qui est le spectre du signal obtenu en sortie du mélangeur 10. Si l'on se réfère à l'étude de non linéarité de l'amplificateur faite précédemment, on s'aperçoit que ce spectre comporte des composantes situées aux mêmes fréquences que le spectre qui serait obtenu après une amplification non linéaire du signal d'entrée à travers l'amplificateur 1 non corrigé. On voit donc qu'en choisissant correctement les valeurs A', B' et C', il est possible de neutraliser les composantes de fréquence $2f_1 - f_2$, $2f_2 - f_1$, $3f_1 - 2f_2$ et $3f_2 - 2f_1$ dues à la non linéarité de l'amplificateur 1.

Pour cela l'opérateur contrôle l'amplitude et le signe, de chacune des composantes de sortie du circuit sommateur 9 en agissant sur le réglage du gain des amplificateurs 7 et 8 et sur le réglage des signes à affecter aux signaux d'entrée du circuit sommateur 9. Le réglage se fait dans l'ordre décroissant des raies d'intermodulation à éliminer en obsevant à chaque étape du réglage l'évolution du signal de sortie de l'amplificateur 1. Il consiste d'abord à minimiser les composantes situées aux fréquences $3f_1 - 2f_2$ et $3f_2 - 2f_1$ par action sur l'amplificateur linéaire à gain réglable 8, ce qui modifie également les composantes situées aux fréquences $2f_1 - f_2$ et $2f_2 - f_1$. Il consiste ensuite à minimiser les nouvelles composantes situées aux fréquences $2f_1 - f_2$ et $2f_2 - f_1$ par action sur l'amplificateur linéaire à gain réglable 7, ce qui joue un peu sur le niveau

des fréquences $f_1$ et $f_2$, mais ceci n'est pas gênant. A la fin du réglage, le spectre du signal de sortie de l'amplificateur non linéaire 1 comporte des raies d'intermodulation très affaiblies.

Les produits d'intermodulation dus à la non linéarité de l'amplificateur 1 appliquée aux signaux de correction issus du mélangeur 10 ont un niveau très faible et sont de ce fait négligeables.

A titre d'exemple la description du fonctionnement du dispositif de correction de non linéarité conforme à l'invention a été faite pour un signal d'entrée comportant deux tons égaux, mais le principe de l'invention est inchangé pour un signal d'entrée comportant un nombre quelconque de tons eux-mêmes quelconques.

8

## REVENDICATIONS

1. Dispositif de correction d'intermodulation produite par un amplificateur (1) de signaux haute fréquence, caractérisé en ce qu'il comporte des moyens (2) pour élaborer, à partir du signal à amplifier, des signaux de correction, d'amplitude réglable, aux fréquences des produits d'intermodulation d'ordres impairs,ces moyens (2) fournissant le signal d'entrée de l'amplificateur (1), ce qui permet de corriger les produits d'intermodulation d'ordres impairs produits par l'amplificateur (1), le produit des fonctions de transfert des moyens (2) et de l'amplificateur (1) ne donnant pas nécessairement une fonction de transfert linéaire.

2. Dispositif de correction d'intermodulation selon la revendication 1, caractérisé en ce qu'un détecteur d'enveloppe (3) du signal à amplifier est prévu en amont des moyens (2) pour élaborer des signaux de correction aux fréquences des produits d'intermodulation à corriger.

3. Dispositif selon les revendications 1 et 2, caractérisé en ce que les moyens (2) pour élaborer des signaux de correction aux fréquences des produits d'intermodulation à corriger comportent premièrement N multiplieurs (5, 6), dont le premier est muni de deux entrées reliées à la sortie du détecteur d'enveloppe (3), dont le deuxième est muni de deux entrées reliées à la sortie du premier et dont le $n^{ième}$ (n étant entier compris entre 3 et N) est muni de deux entrées reliées respectivement à la sortie du premier et du $(n-1)^{ième}$, deuxièmement N amplificateurs linaires à gain réglable (7,8) munis chacun d'une entrée reliée à la sortie de l'un des N multiplieurs, troisièmement un circuit sommateur (9) muni de "N+1" entrées dont N sont reliées aux sorties des amplificateurs linéaires à gain réglable, et dont la $(N+1)^{ième}$ est destinée à recevoir une valeur constante réglable, et d'une sortie qui constitue la sortie du précorrecteur, le circuit sommateur étant apte à fonctionner en additionneur ou en soustracteur relativement à chacune de ses entrées, et quatrièmement un mélangeur (10) muni d'une première entrée destinée à recevoir le signal d'entrée, d'une deuxième entrée reliée à la sortie du circuit sommateur (9), et d'une sortie reliée à l'entrée de l'amplificateur (1).

Fig.1

Fig.2

**Office européen des brevets**

# RAPPORT DE RECHERCHE EUROPEENNE

EP 82 40 0901.3

| | DOCUMENTS CONSIDERES COMME PERTINENTS | | CLASSEMENT DE LA DEMANDE (Int. Cl. 3) |
|---|---|---|---|
| Catégorie | Citation du document avec indication, en cas de besoin, des parties pertinentes | Revendication concernée | |
| X,Y | DE - A1 - 2 424 491 (H.H. PLISCH)<br>* revendication 1; fig. 1 *<br>--- | 1-3 | H 03 F 1/32 |
| Y | ELECTRONICS INTERNATIONAL, Vol. 53, No. 20<br>11 septembre 1980, New York<br>J. GOSCH "Universally Applicable Technique Linearizes Microwave Power Amp Tubes"<br>* page 82; fig. 1 (b) *<br>--- | 2 | |
| D,Y | DE - A - 2 306 294 (ROHDE & SCHWARZ)<br>* fig. 1 *<br>--- | 3 | H 03 F 1/32 |
| A | Patent Abstracts of Japan<br>Vol. 3, No. 48, 24 avril 1979<br>page 119E106<br>& JP - A - 54 - 27341<br>--- | | H 04 B 3/06<br>H 04 N 5/38 |
| A | DE - A1 - 2 656 436 (LICENTIA PATENT-VERWALTUNG)<br>* fig. 1 *<br>--- | | |
| A | US - A - 3 755 754 (J.L. PUTZ)<br>* fig. 1 *<br>---- | | |

| | |
|---|---|
| **DOMAINES TECHNIQUES RECHERCHES (Int. Cl. 3)** | |

**CATEGORIE DES DOCUMENTS CITES**

X: particulièrement pertinent à lui seul
Y: particulièrement pertinent en combinaison avec un autre document de la même catégorie
A: arrière-plan technologique
O: divulgation non-écrite
P: document intercalaire
T: théorie ou principe à la base de l'invention
E: document de brevet antérieur, mais publié à la date de dépôt ou après cette date
D: cité dans la demande
L: cité pour d'autres raisons

&: membre de la même famille, document correspondant

Ⅹ Le présent rapport de recherche a été établi pour toutes les revendications

| Lieu de la recherche | Date d'achèvement de la recherche | Examinateur |
|---|---|---|
| Berlin | 13-08-1982 | BREUSING |

OEB Form 1503.1   06.78